# FASCICULE DE BREVET EUROPEEN

(11) **EP 1 973 392 B1**
(45) Date de publication et mention de la délivrance du brevet: **01.09.2010**
(21) Numéro de dépôt: 08356052.4
(22) Date de dépôt: 20.03.2008
(51) Int. Cl.: H05K 1/18, H01H 37/52, H01H 37/04

(54) **Dispositif de sécurité et de commande d'un appareil électrodomestique**
Sicherheits- und Steuervorrichtung für elektrisches Haushaltsgerät
Safety and control device for a home electrical appliance

(30) Priorité: 23.03.2007 FR 0702113
(43) Date de publication de la demande: 24.09.2008
(73) Titulaire: Cotherm, F-38470 Vinay (FR)
(72) Inventeur: Roques, Bernard, 38850 Bilieu (FR)
(74) Mandataire: Schmitt, John

(56) Documents cités:
- WO-A-2007/098760
- DE-A1- 4 409 123
- US-A- 4 795 997
- US-A- 5 046 156

## Description

La présente invention est relative à un dispositif de sécurité et de commande d'un appareil électrodomestique, comme par exemple, un chauffe-eau ou tout autre appareil tel qu'un appareil de chauffage électrique à usage particulier ou collectif.

Un exemple d'un appareil électrodomestique de chauffage est démontré dans le document DE 4409123.

Le dispositif de sécurité et de commande d'un appareil électrodomestique suivant la présente invention, comporte une carte électronique qui est constituée d'une plaque isolante comportant un circuit imprimé alimentant un système électronique de commande permettant le pilotage d'un appareil électrodomestique un dispositif de sécurité électromécanique connecté au circuit imprimé et constitué d'un corps isolant solidaire d'un capillaire ou d'un disque bimétallique de sécurité.

Le dispositif de sécurité et de commande d'un appareil électrodomestique suivant la présente invention comporte un corps comprenant, sur chacun de ses cotés des fiches d'alimentation disposées par paire et réalisées dans des fines lames métalliques présentant une extrémité effilée.

Le dispositif de sécurité et de commande d'un appareil électrodomestique suivant la présente invention, comporte un corps comprenant, sur sa face, opposée à celle recevant le capillaire ou le disque bimétallique de sécurité, d'une part en son milieu une jupe cylindrique de centrage et d'autre part à proximité de la jupe cylindrique et sur un même axe que cette dernière un alésage taraudé.

Le dispositif de sécurité et de commande d'un appareil électrodomestique suivant la présente invention, comporte un dispositif de sécurité électromécanique comprenant une paire de fiche qui est constituée par des bornes à vis ou analogue permettant une connexion aux phases d'alimentation électrique du réseau électrique.

Le dispositif de sécurité et de commande d'un appareil électrodomestique suivant la présente invention comporte des fiches dont le profil effilé coopère avec des trous ménagés dans la plaque isolante afin d'être raccordées aux circuits imprimés par un point de soudure.

Le dispositif de sécurité et de commande d'un appareil électrodomestique suivant la présente invention comporte une plaque isolante pourvue sur l'une de ses faces d'un circuit imprimé alimentant un système électronique de commande permettant le pilotage d'un appareil électrodomestique et sur l'autre face d'un dispositif de sécurité électromécanique connecté au circuit imprimé.

La description qui va suivre en regard des dessins annexés, donnés à titre d'exemples non limitatifs, permettra de mieux comprendre l'invention, les caractéristiques qu'elle présente et les avantages qu'elle est susceptible de procurer :
Figures 1 et 2 sont des vues en perspective éclatée illustrant le dispositif de sécurité et de commande avant son assemblage suivant la présente invention.
Figure 3 et 4 sont des vues en perspective montrant le dispositif de sécurité et de commande en position assemblée suivant la présente invention.
Figures 5 et 6 sont des vues en perspective représentant une variante de la connexion du dispositif de sécurité et de commande en position assemblée suivant la présente invention.

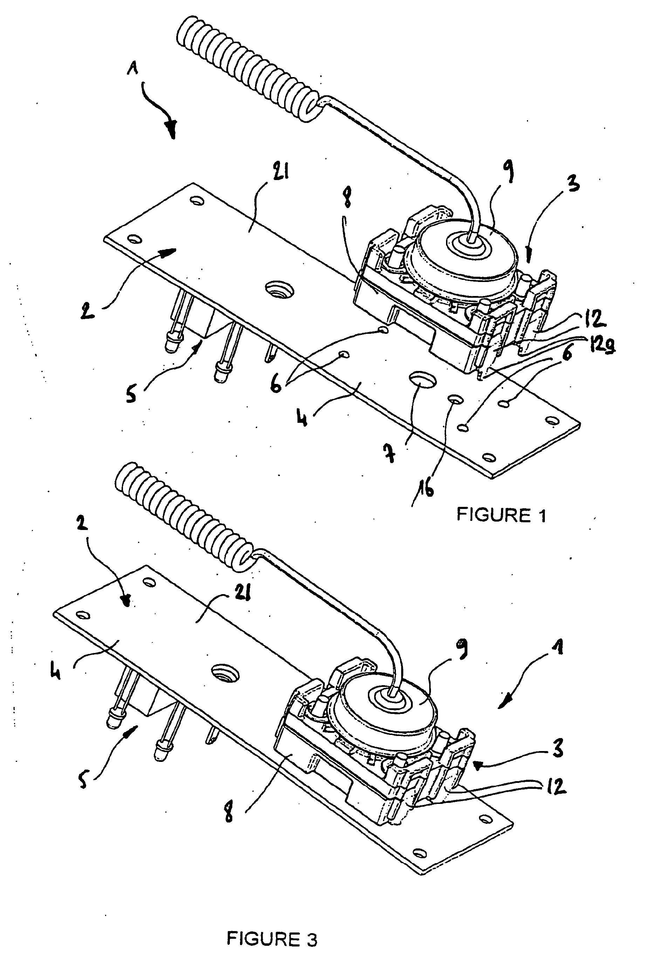

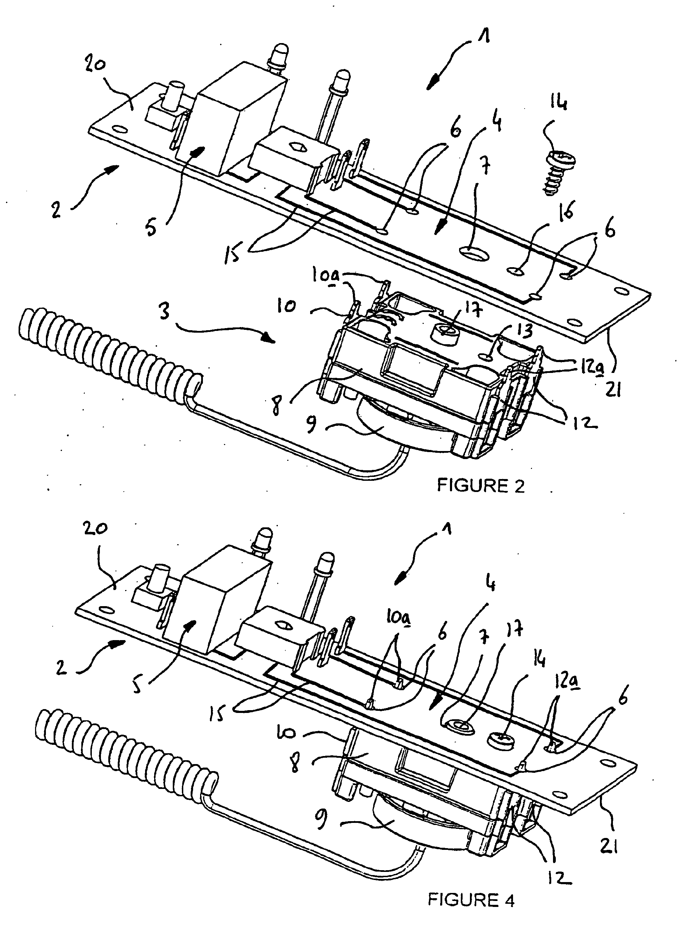

On a montré en figures 1 à 4 un dispositif de sécurité et de commande 1 comportant une carte électronique 2 et un dispositif de sécurité électromécanique 3.

La carte électronique 2 est constituée d'une plaque isolante 4 comportant sur l'une de ses faces 20 un circuit imprimé 15 alimentant un système électronique de commande 5 permettant le pilotage d'un appareil électrodomestique.

La plaque isolante 4 est percée de trous 6, 7 et 16 permettant la fixation et la connexion au circuit imprimé 15 du dispositif de sécurité électromécanique 3.

Le dispositif de sécurité électromécanique 3 est constitué d'un corps 8 réalisé dans en matériau isolant et solidaire d'un capillaire ou d'un disque bimétallique de sécurité 9.

Le corps 8 comporte, sur chacun de ses cotés des fiches d'alimentation 10, 12 disposées par paires et réalisées dans des fines lames métalliques présentant une extrémité effilée 10**a**, 12**a**.

Le corps 8 comporte sur sa face, opposée à celle recevant le capillaire ou le disque bimétallique de sécurité 9, d'une part en son milieu une jupe cylindrique de centrage 17 et d'autre part à proximité de la jupe cylindrique 17 et sur un même axe que cette dernière un alésage taraudé 13.

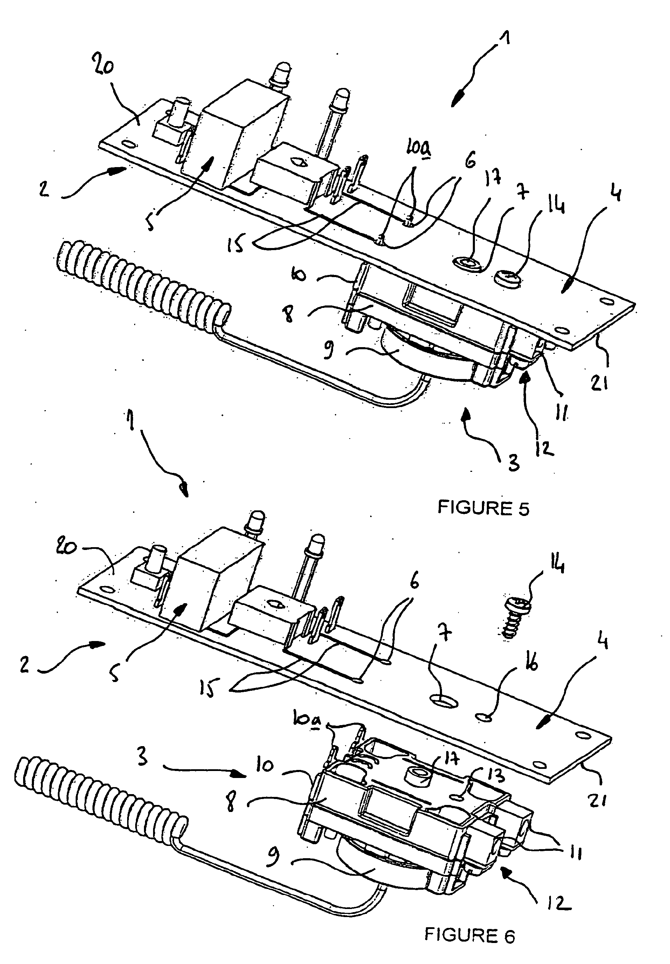

Le dispositif de sécurité électromécanique 3 peut comporter en variante au moins une paire de fiches 10, 12 qui est constituée par des bornes à vis 11 ou analogue permettant une connexion aux phases d'alimentation électrique du réseau électrique (figures 5 et 6).

Le dispositif de sécurité électromécanique 3 est fixé sur la plaque électronique 4 et plus particulièrement sur la face 21 opposée à celle 20 recevant le système électronique de commande 5.

Le dispositif de sécurité électromécanique 3 est fixé sur la plaque électronique 4 par l'intermédiaire d'une vis 14 traversant le trou 16 et coopérant avec l'alésage taraudé 13, tandis que la jupe cylindrique 17 traverse le trou 7.

Lors de la fixation du corps 8 sur la plaque électronique 4, au moins l'une des paires de fiches 10, 12 en fonction de sa constitution vient traverser les trous 6 correspondants pour que la pointe du profil effilé 10**a**, 12**a** de chaque fiche débouche au niveau de la face 20 recevant le système électronique de commande 5.

Lorsque les pointes effilées 10**a**, 12**a** des paires de fiches 10, 12 sont placées dans les trous correspondants 6, ces dernières sont raccordées aux circuits imprimés 15 de la plaque électronique 4 par un point de soudure.

En fonction de la constitution des paires de fiches 10, 12 on note que soit les deux paires soit l'une au moins sont raccordées aux circuits imprimés 15 de la plaque électronique 4 par un point de soudure (figures 5 et 6).

Le dispositif de sécurité électromécanique 3 peut comprendre plusieurs paires de fiches de connexion en fonction du nombre de phase aux phases d'alimentation électrique du réseau électrique.

On note que plaque isolante 4 peut comprendre sur une même face le système électronique de commande 5 et le dispositif de sécurité électromécanique 3.

## Revendications

1. Dispositif de sécurité et de commande d'un appareil électrodomestique de chauffage du type chauffe-eau ou appareil de chauffage électrique, **caractérisé en ce qu'**il comporte une carte électronique (2) qui est constituée d'une plaque isolante (4) comportant sur l'une de ses faces (20) un circuit imprimé (15) alimentant un système électronique de commande (5) permettant le pilotage d'un appareil électrodomestique de chauffage et sur l'autre face (21) un dispositif de sécurité électromécanique (3) connecté au circuit imprimé (15), ledit dispositif de sécurité électromécanique (3) étant constitué d'un corps isolant (8) comportant un disque bimétallique ou un capillaire de sécurité (9) et sur sa face; opposée à celle recevant le capillaire ou le disque bimétallique de sécurité (9), d'une part en son milieu une jupe cylindrique de centrage (17) et d'autre part sur chacun de ses cotés des fiches d'alimentation électrique (10, 12) disposées par paire et réalisées dans des fines lames métalliques présentant une extrémité effilée (10a, 12a).

2. Dispositif de sécurité et de commande d'un appareil électrodomestique suivant la revendication 1, **caractérisé en ce que** le corps (8) comporte sur sa face, opposée à celle recevant le capillaire ou le disque bimétallique de sécurité (9), à proximité de la jupe cylindrique (17) et sur un même axe que cette dernière un alésage taraudé (13).

3. Dispositif de sécurité et de commande d'un appareil électrodomestique suivant la revendication 1, **caractérisé en ce que** le dispositif de sécurité électromécanique (3) comporte une paire de fiche (12) qui est constituée par des bornes à vis (11) ou analogue permettant une connexion aux phases d'alimentation électrique du réseau électrique.

4. Dispositif de sécurité et de commande d'un appareil électrodomestique suivant la revendication 1, **caractérisé en ce que** le profil effilé (10a, 12a) de chaque fiche (10, 12) coopère avec des trous (6) ménagés dans la plaque isolante (4) afin d'être raccordé aux circuits imprimés (15) par un point de soudure.

## Claims

1. Safety and control device for a domestic electrical heating appliance of the water heater or electric heating appliance type, **characterized in that** it comprises an electronic card (2) which comprises an insulating plate (4) comprising on one of its sides (20) a printed circuit (15) supplying an electronic control system (5) for driving a domestic electrical heating appliance and on the other side (21) an electromechanical safety device (3) connected to the printed circuit (15), said electromechanical safety device comprising an insulating body (8) comprising a bimetallic disk or a safety capillary (9) and on its side opposite to that receiving the capillary or the bimetallic safety disk (9), on the one hand, in its middle, a centering cylindrical skirt (17) and, on the other hand, on each of its sides, electrical power supply plugs (10, 12) arranged in pairs and produce in thin metal blades having a tapered end (10a, 12a).

2. Safety and control device for a domestic electrical appliance according to Claim 1, **characterized in that** the body (8) comprises on its side opposite to that receiving the capillary or the bimetallic safety disk (9), close to the cylindrical skirt (17) and on one and the same axis as the latter, a tapped hole (13).

3. Safety and control device for a domestic electrical appliance according to Claim 1, **characterized in that** the electromechanical safety device (3) comprises a pair of plugs (12) comprising screw terminals (11) or similar, enabling a connection to the electrical power supply phases of the electricity network.

4. Safety and control device for a domestic electrical appliance according to Claim 1, **characterized in that** the tapered profile (10a, 12a) of each plug (10, 12) cooperates with holes (6) provided in the insulating plate (4) in order to be connected to the printed circuits (15) by a spot of solder.

## Patentansprüche

1. Sicherheits- und Steuervorrichtung eines elektrischen Haushaltsheizgeräts von der Art Warmwasserbereiter oder elektrisches Heizgerät, **dadurch gekennzeichnet, dass** sie eine Elektronikkarte (2) aufweist, die aus einer Isolierplatte (4) besteht, welche auf einer ihrer Seiten (20) eine gedruckte Schaltung (15), die ein elektronisches Steuersystem (5) versorgt, das die Steuerung eines elektrischen Haushaltsheizgeräts erlaubt, und auf ihrer anderen Seite (21) eine mit der gedruckten Schaltung (15) verbundene elektromechanische Sicherheitsvorrichtung (3) aufweist, wobei die elektromechanische Sicherheitsvorrichtung (3) aus einem Isolierkörper (8) besteht, der eine Sicherheits-Bimetallscheibe oder ein Sicherheits-Kapillarrohr (9) und auf seiner Seite entgegengesetzt zu derjenigen, die das Sicherheits-Kapillarrohr oder die Sicherheits-Bimetallscheibe (9) aufnimmt, einerseits in seiner Mitte eine zylindrische Zentrierschürze (17) und andererseits auf jeder seiner Seiten Stromversorgungsstecker (10, 12) aufweist, die paarweise angeordnet und aus dünnen Metalllamellen hergestellt sind, welche ein verjüngtes Ende (10a, 12a) aufweisen.

2. Sicherheits- und Steuervorrichtung eines elektrischen Haushaltsgeräts nach Anspruch 1, **dadurch gekennzeichnet, dass** der Körper (8) auf seiner Seite entgegengesetzt zu derjenigen, die das Sicherheits-Kapillarrohr oder die Sicherheits-Bimetallscheibe (9) aufnimmt, in der Nähe der zylindrischen Schürze (17) und auf der gleichen Achse wie diese eine Gewindebohrung (13) aufweist.

3. Sicherheits- und Steuervorrichtung eines elektrischen Haushaltsgeräts nach Anspruch 1, **dadurch gekennzeichnet, dass** die elektromechanische Sicherheitsvorrichtung (3) ein Steckerpaar (12) aufweist, das aus Schraubenklemmen (11) oder Ähnlichem besteht, die eine Verbindung mit den Stromversorgungsphasen des Stromnetzes erlauben.

4. Sicherheits- und Steuervorrichtung eines elektrischen Haushaltsgeräts nach Anspruch 1, **dadurch gekennzeichnet, dass** das verjüngte Profil (10a, 12a) jedes Steckers (10, 12) mit in der Isolierplatte (4) ausgebildeten Löchern (6) zusammenwirkt, um über einen Schweißpunkt mit den gedrückten Schaltungen (15) verbunden zu werden.
